# EUROPEAN PATENT APPLICATION

(11) **EP 4 831 696 A1**
(43) Date of publication of application: **28.10.2026**
(21) Application number: 24907094.7
(22) Date of filing: 27.11.2024
(51) Int. Cl.: G02B 1/04, C23C 14/08, C23C 14/20, C23C 14/24, C23C 14/30, G02B 1/10, G02B 1/14, G02B 1/115, G02B 3/00

(54) **METHOD FOR MANUFACTURING OPTICAL COMPONENT**

(30) Priority: 22.12.2023 JP 2023216791
(71) Applicant: MITSUBISHI GAS CHEMICAL COMPANY, INC., Chiyoda-ku Tokyo 100-8324 (JP)
(72) Inventor: OKABE Yuta, Tokyo 125-8601 (JP); NYUUI Tatsuki, Tokyo 125-8601 (JP); TSURUYA Hirotaka, Tokyo 125-8601 (JP)
(74) Representative: Vossius & Partner Patentanwälte Rechtsanwälte mbB
(86) International application number: PCT/JP2024/041900
(87) International publication number: WO 2025/134706

(57) **Abstract**

Through the present invention, it is possible to provide a method for manufacturing an optical component, the method comprising a step for producing a molded body by molding a resin composition, and a step for forming an optical thin film on at least a portion of the surface of the molded body, wherein the resin composition contains a vinyl copolymer resin (A) including a constituent unit (a) represented by general formula (1) and a constituent unit (b) represented by general formula (2), and the step for forming the optical thin film comprises forming a SiOₓ layer (x is 1.5-2.0) having a thickness of 0.5-2.0 µm on a first layer by a resistance heating vapor deposition method, and furthermore forming a laminate in which a plurality of metal oxide layers and/or non-metal oxide layers are laminated by an electron beam vapor deposition method after a second layer.

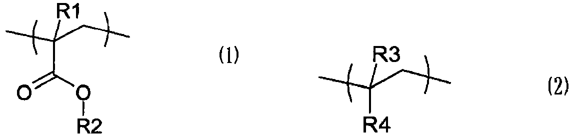

## Description

### TECHNICAL FIELD

The present invention relates to a method for manufacturing an optical component.

### BACKGROUND ART

Transparent thermoplastic resins are lighter than glass and can be easily molded into complicated shapes, and therefore are used as materials for optical components of cameras, displays, projectors, copy machines, microscopes, etc. On the surface of a transparent thermoplastic resin molded body to be used for optical component applications, an optical thin film is often formed in order to impart optical functions of anti-reflection mirrors, beam splitters, filters, etc.

Among transparent thermoplastic resin materials, polymethyl methacrylate (PMMA) is excellent in transparency, optical isotropy, surface hardness, weather resistance, and moldability. However, when the widely used vacuum deposition method using electron gun heating is employed for forming the above-described optical thin film, there is a problem that the adhesion between the PMMA substrate and the optical thin film is insufficient and the optical thin film easily peels off. When a vacuum deposition method using resistance heating (Patent Document 1), a film formation method that prevents reflected electrons generated during electron gun heating from reaching the substrate (Patent Document 2), or the like is employed, the initial adhesion between the PMMA substrate and the optical thin film is improved, but under high-temperature and high-humidity conditions, cracks and haze are caused in the optical thin film and the size and optical characteristics change, and this may be problematic depending on intended use. Therefore, it has been difficult to obtain an optical component that is excellent in transparency, optical isotropy, surface hardness, weather resistance, and moldability and also excellent in durability under high-temperature and high-humidity conditions.

### PRIOR ART DOCUMENTS

### PATENT DOCUMENTS

Patent Document 1: Japanese Laid-Open Patent Publication No. H07-63903
Patent Document 2: Japanese Patent No. 5280149

### DISCLOSURE OF THE INVENTION

### PROBLEMS TO BE SOLVED BY THE INVENTION

Under the above-described circumstances, the present invention addresses the problem of solving at least one of the above-described conventional problems. The present invention further addresses the problem of providing a method for manufacturing an optical component that is excellent in adhesion of an optical thin film and also excellent in durability under high-temperature and high-humidity conditions.

### MEANS FOR SOLVING THE PROBLEMS

The present inventors diligently made researches in order to solve the above-described problems, and found that the problems can be solved by carrying out a step of forming an optical thin film on a molded body, wherein in the step: a specific SiOₓ layer as a first layer is formed by a resistance heating vapor deposition method; and a laminate in which a plurality of metal oxide layers and/or non-metal oxide layers are laminated as second and subsequent layers is further formed by an electron beam vapor deposition method.

Specifically, the present invention is as follows:
<1> A method for manufacturing an optical component, the method comprising
   a step of producing a molded body by molding a resin composition, and
   a step of forming an optical thin film on at least a portion of the surface of the molded body, wherein:
      the resin composition contains a vinyl copolymer resin (A) comprising a structural unit (a) represented by general formula (1) and a structural unit (b) represented by general formula (2): 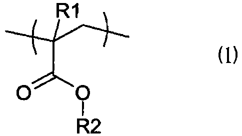
      wherein in general formula (1): R1 represents a hydrogen atom or a methyl group; R2 represents a group having 1 to 16 carbon atoms which has a hydrocarbon group, which may have a hydroxyl group or an alkoxy group; and in the case where a plurality of the structural units (a) exist, R1 and R2 respectively may be the same or different from each other, 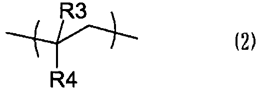
      wherein in general formula (2): R3 represents a hydrogen atom or a methyl group; R4 represents a phenyl group, a cyclohexadienyl group, a cyclohexenyl group or a cyclohexyl group, which may have at least one substituent selected from the group consisting of a hydrocarbon group having 1 to 4 carbon atoms, a hydroxyl group, an alkoxy group and a halogen atom; and in the case where a plurality of the structural units (b) exist, R3 and R4 respectively may be the same or different from each other; and
      the step of forming the optical thin film comprises forming a SiOₓ layer (x is 1.5 to 2.0) having a thickness of 0.5 to 2.0 µm as a first layer by a resistance heating vapor deposition method, and furthermore forming a laminate in which a plurality of metal oxide layers and/or non-metal oxide layers are laminated as second and subsequent layers by an electron beam vapor deposition method.
<2> The method according to item <1>, wherein the metal oxide layers are TiO₂ layers and the non-metal oxide layers are SiO₂ layers.
<3> The method according to item <1>, wherein the laminate is obtained by laminating 2 to 20 metal oxide layers and/or non-metal oxide layers.
<4> The method according to item <1>, wherein the laminate has a thickness of 0.1 to 1 µm.
<5> The method according to item <1>, wherein the molded body has a thickness of 0.5 to 20 mm.
<6> The method according to item <1>, wherein in general formula (1), R1 and R2 represent a methyl group, and wherein in general formula (2): R3 represents a hydrogen atom; and R4 represents a cyclohexyl group which does not have a substituent.
<7> The method according to item <1>, wherein the ratio of the structural unit (a) to the total of the structural units (a) and (b) is 30 to 80 mol%.
<8> The method according to item <1>, wherein the step of forming the optical thin film comprises flowing oxygen gas under vacuum to adjust the absolute pressure to 0.01 to 0.04 PaA, and forming a SiOₓ layer (x is 1.5 to 2.0) having a thickness of 0.5 to 2.0 µm as a first layer by a resistance heating vapor deposition method.

### ADVANTAGEOUS EFFECT OF THE INVENTION

According to the present invention, a method for manufacturing an optical component that is excellent in adhesion of an optical thin film and also excellent in durability under high-temperature and high-humidity conditions is provided. The optical component obtained by the manufacturing method can be suitably used for, for example, lenses for cameras, displays, projectors, copy machines, microscopes, etc., light guide bodies, prisms, mirrors, beam splitters, filters, etc. In particular, it can be suitably used for lenses for VR.

### EMBODIMENTS FOR CARRYING OUT THE INVENTION

Hereinafter, the present invention will be described in detail. Note that the present invention is not limited to the below-described embodiments, and can be arbitrarily changed and then carried out within a range in which the effects of the present invention are exerted.

### <Step of Producing Molded Body>

The method for manufacturing an optical component of the present invention includes a step of producing a molded body by molding a resin composition, and a step of forming an optical thin film on at least a portion of the surface of the molded body.

In this regard, the resin composition contains a vinyl copolymer resin (A) including a structural unit (a) represented by general formula (1) and a structural unit (b) represented by general formula (2).

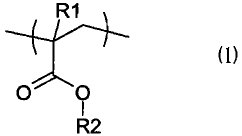

In general formula (1): R1 represents a hydrogen atom or a methyl group; R2 represents a group having 1 to 16 carbon atoms which has a hydrocarbon group, which may have a hydroxyl group or an alkoxy group; and in the case where a plurality of the structural units (a) exist, R1 and R2 respectively may be the same or different from each other.

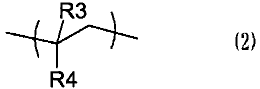

In general formula (2): R3 represents a hydrogen atom or a methyl group; R4 represents a phenyl group, a cyclohexadienyl group, a cyclohexenyl group or a cyclohexyl group, which may have at least one substituent selected from the group consisting of a hydrocarbon group having 1 to 4 carbon atoms, a hydroxyl group, an alkoxy group and a halogen atom; and in the case where a plurality of the structural units (b) exist, R3 and R4 respectively may be the same or different from each other.

The structural unit (a) is a structural unit derived from a (meth)acrylic acid ester monomer which will be described later, and R1 is a hydrogen atom or a methyl group. In this regard, "(meth)acrylic acid" indicates "methacrylic acid and/or acrylic acid". Further, R2 is a group having 1 to 16 carbon atoms which has a hydrocarbon group, which may have a hydroxyl group or an alkoxy group. Specific examples thereof include: an alkyl group such as a methyl group, an ethyl group, a butyl group, a lauryl group, a stearyl group, a cyclohexyl group, and an isobornyl group; a hydroxyalkyl group such as a 2-hydroxyethyl group, a 2-hydroxypropyl group, and a 2-hydroxy-2-methylpropyl group; an alkoxyalkyl group such as a 2-methoxyethyl group and a 2-ethoxyethyl group; and an aryl group such as a benzyl group and a phenyl group. In the vinyl copolymer resin (A), R1 and R2 respectively may be the same or different from each other.

As the structural unit (a), a (meth)acrylic acid ester structural unit in which R2 is a methyl group and/or an ethyl group is preferred, and a methyl methacrylate structural unit in which R1 is a methyl group and R2 is methyl group is more preferred.

The structural unit (b) is represented by general formula (2) above. In the case of the structural unit (b), in which R4 is a group having a 6-membered ring other than the phenyl group, it is obtained by the method for producing the vinyl copolymer resin (A) which will be described later, in which a (meth)acrylic acid ester monomer is copolymerized with an aromatic vinyl monomer which will be described later, and then the benzene ring in the aromatic vinyl monomer is hydrogenated to produce the vinyl copolymer resin (A). In the case where the benzene ring is hydrogenated, the benzene ring becomes a cyclohexyl group when the hydrogenation completely proceeds, and the benzene ring becomes a cyclohexenyl group or a cyclohexadienyl group when the hydrogenation partially proceeds. Further, it is considered that there is a case where hydrogenation is not caused and the benzene ring, i.e., the phenyl group remains. Examples of the hydrocarbon group having 1 to 4 carbon atoms include a methyl group, an ethyl group, a propyl group, an isopropyl group, a butyl group, an isobutyl group, and a tert-butyl group. The alkoxy group usually has 1 to 14 carbon atoms, and specific examples thereof include a methoxy group, an ethoxy group, a propoxy group, an isopropoxy group, a butoxy group, an isobutoxy group, and a tert-butoxy group. Examples of the halogen atom include F, Cl, Br, and I. The vinyl copolymer resin (A) usually has a plurality of structural units (b), and in this case, R3 and R4 respectively may be the same or different from each other.

Further, the structural unit (b) may be a structural unit derived from an aliphatic vinyl monomer which will be described later. That is, in the case where a (meth)acrylic acid ester monomer is copolymerized with an aliphatic vinyl monomer to produce the vinyl copolymer resin (A) as described later, the structural unit (b) is a structural unit derived from the aliphatic vinyl monomer.

In the vinyl copolymer resin (A), the ratio of hydrogenation of the benzene ring in the structural unit (b) is preferably 80% or more. When the ratio of hydrogenation is less than 80%, the transparency may be reduced. The ratio is more preferably 90% or more, and even more preferably 95% or more. The case where the ratio of hydrogenation of the benzene ring in the structural unit (b) is 80% or more means that the ratio of the number of R4 that are a cyclohexadienyl group, a cyclohexenyl group or a cyclohexyl group, which may have a substituent, to the number of all R4 in the structural units (b) is 80% or more. The case where the ratio of the number is 80% or more means that, for example, when 100 structural units (b) exist, 80 or more of 100 R4 are a cyclohexadienyl group, a cyclohexenyl group or a cyclohexyl group.

The ratio of hydrogenation can be obtained based on the decrease ratio of the absorbance at 260 nm in the UV spectrum measurement of the resin before and after hydrogenation reaction (corresponding to absorption of the benzene ring).

The vinyl copolymer resin (A) is mainly composed of the structural unit (a) and the structural unit (b). The ratio of the structural unit (a) is preferably 30 to 80 mol%, and more preferably 60 to 80 mol% relative to the total of the structural unit (a) and the structural unit (b). When the ratio of the structural unit (a) relative to the total of the structural unit (a) and the structural unit (b) is less than 30 mol%, the surface hardness may be reduced and the adhesion to a hard coat paint may be reduced, and it is not practical. Further, when the ratio is more than 80 mol%, under high-temperature and high-humidity conditions, a crack and haze may be caused in an optical thin film and the size and optical properties thereof may change, and it is not practical.

The vinyl copolymer resin (A) is not particularly limited, and preferred are one obtained by copolymerizing a (meth)acrylic acid ester monomer with an aromatic vinyl monomer, followed by hydrogenation of an aromatic double bond derived from the aromatic vinyl monomer, and one obtained by copolymerizing a (meth)acrylic acid ester monomer with an aliphatic vinyl monomer. The former is particularly preferred.

The (meth)acrylic acid ester monomer to be used in this case preferably has 4 to 20 carbon atoms. The (meth)acrylic acid ester monomer having 4 to 20 carbon atoms is not particularly limited, and specific examples thereof include methyl (meth)acrylate, ethyl (meth)acrylate, butyl (meth)acrylate, lauryl (meth)acrylate, stearyl (meth)acrylate, cyclohexyl (meth)acrylate, isobornyl (meth)acrylate, (2-hydroxyethyl) (meth)acrylate, (2-hydroxypropyl) (meth)acrylate, (2-hydroxy-2-methylpropyl) (meth)acrylate, (2-methoxyethyl) (meth)acrylate, (2-ethoxyethyl) (meth)acrylate, benzyl (meth)acrylate, phenyl (meth)acrylate, and 2-(meth)acryloyloxyethyl phosphorylcholine. Among them, methyl methacrylate is preferred.

Specific examples of the aromatic vinyl monomer include styrene, α-methylstyrene, o-methylstyrene, p-hydroxystyrene, alkoxystyrene, chlorostyrene, and derivatives thereof. Among them, styrene and α-methylstyrene are preferred.

Specific examples of the aliphatic vinyl monomer include vinylcyclohexane, isopropenylcyclohexane, and 1-isopropenyl-2-methylcyclohexane. Among them, vinylcyclohexane is preferred.

Hereinafter, the method for hydrogenation of an aromatic double bond derived from the aromatic vinyl monomer after copolymerizing the (meth)acrylic acid ester monomer with the aromatic vinyl monomer will be described. For polymerizing the (meth)acrylic acid ester monomer and the aromatic vinyl monomer, a publicly-known method can be used, and for example, by a bulk polymerization method, a suspension polymerization method or a solution polymerization method, the vinyl copolymer resin (A) can be produced. The solution polymerization method is carried out, for example, by a method of continuously supplying a monomer composition containing monomers, a chain transfer agent and a polymerization initiator to a complete mixing tank to perform continuous polymerization at 100 to 180°C.

Examples of the solvent to be used in this case include a hydrocarbon-based solvent such as toluene, xylene, cyclohexane, and methylcyclohexane; an ester-based solvent such as ethyl acetate and methyl isobutyrate; a ketone-based solvent such as acetone and methyl ethyl ketone; an ether-based solvent such as tetrahydrofuran and dioxane; and an alcohol-based solvent such as methanol and isopropanol.

The hydrogenation reaction of the aromatic double bond after the polymerization of the (meth)acrylic acid ester monomer and the aromatic vinyl monomer is preferably performed in a solvent. The solvent to be used in the hydrogenation reaction may be the same as or different from the aforementioned polymerization solvent. Examples thereof include a hydrocarbon-based solvent such as cyclohexane and methylcyclohexane; an ester-based solvent such as ethyl acetate and methyl isobutyrate; a ketone-based solvent such as acetone and methyl ethyl ketone; an ether-based solvent such as tetrahydrofuran and dioxane; and an alcohol-based solvent such as methanol and isopropanol.

The method for hydrogenation is not particularly limited, and a publicly-known method can be used. For example, hydrogenation can be performed at a hydrogen pressure of 3 to 30 MPa and a reaction temperature of 60 to 250°C by means of a batch type or continuous flow-type reaction. When the temperature is set to 60°C or higher, the reaction time is not too long, and when the temperature is set to 250°C or lower, cut of a molecular chain and hydrogenation of an ester moiety are hardly caused.

Examples of the catalyst to be used in the hydrogenation reaction include a solid catalyst in which a metal such as nickel, palladium, platinum, cobalt, ruthenium and rhodium, or an oxide, salt or complex of the metal is carried by a porous carrier such as carbon, alumina, silica, silica-alumina, zirconia and diatomaceous earth.

Further, the polymerization of the (meth)acrylic acid ester monomer and the aliphatic vinyl monomer can be carried out by publicly-known methods, for example, the methods described in Japanese Laid-Open Patent Publication No. S63-3011 and Japanese Laid-Open Patent Publication No. S63-170475.

In the present invention, the resin composition containing the vinyl copolymer resin (A) may contain another resin as long as transparency of the product is not impaired. Examples of said another resin that may be contained in the resin composition include methyl methacrylate/styrene copolymer resin, methyl methacrylate/styrene/maleic anhydride copolymer resin, styrene/methacrylic acid copolymer resin, styrene/maleic anhydride copolymer resin, poly(methyl methacrylate), polystyrene, norbornene-based resin, and polycarbonate.

Various additives may be used to be mixed with the vinyl copolymer resin (A). Examples of the additives include an ultraviolet absorber, an antioxidant, an anti-coloring agent, an antistatic agent, a mold release agent, a lubricant, a dye, a pigment, and an impact resistance agent. The mixing method is not particularly limited, and it is possible to use a method of compounding the total amount of the additives, a method of dry-blending a master batch, a method of dry-blending the total amount of the additives, or the like.

The molded body to be used in the present invention is obtained by molding the above-described resin composition, and may be obtained by any molding method. Regarding the molding method, molding can be performed by a publicly-known method such as injection molding, extrusion molding, hot pressing, solvent casting, and inflation molding.

In the present invention, the thickness of the molded body is preferably 0.5 to 20 mm, and more preferably 1 to 10 mm.

### <Optical Thin Film Forming Step>

In the present invention, the step of forming the optical thin film includes forming a SiOₓ layer (x is 1.5 to 2.0) having a thickness of 0.5 to 2.0 µm as a first layer by a resistance heating vapor deposition method, and furthermore forming a laminate in which a plurality of metal oxide layers and/or non-metal oxide layers are laminated as second and subsequent layers by an electron beam vapor deposition method.

When forming the above-described first layer, oxygen gas is flowed under vacuum to adjust the absolute pressure to preferably 0.01 to 0.04 PaA, and more preferably 0.02 to 0.03 PaA.

Note that the absolute pressure means "pressure defined based on a complete vacuum (absolute vacuum)" and is expressed by the following relationship.

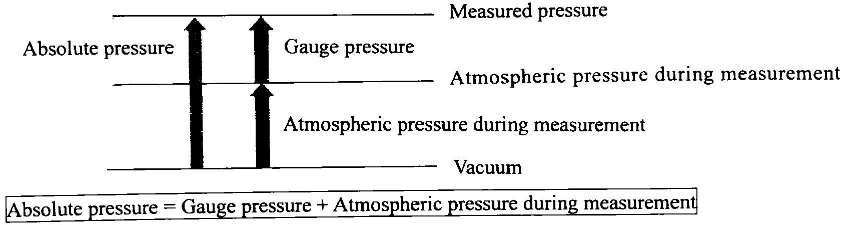

When an optical thin film is formed on the surface of a molded body by electron beam, polymethyl methacrylate (PMMA) constituting the molded body is decomposed and deteriorated by the electron beam. In the present invention, since the SiOₓ layer is formed as the first layer on the surface of the molded body by the resistance heating vapor deposition method, the influence of the electron beam on PMMA can be suppressed. Therefore, when the optical thin film is formed on the surface of the molded body, good adhesion can be achieved.

In the present invention, as the method for forming the SiOₓ layer by means of the resistance heating vapor deposition method, a generally known method can be employed. Specifically, in a vacuum deposition apparatus, an electric current is passed through a resistor such as W, Mo and B to generate heat, and a vapor deposition material is heated and evaporated, thereby forming a thin film.

In the present invention, the thickness of the SiOₓ layer formed as the first layer is 0.5 to 2.0 µm, preferably 0.7 to 1.8 µm, and more preferably 0.9 to 1.6 µm. When the thickness of the SiOₓ layer is less than 0.5 µm, the adhesion of the optical thin film is poor, and peeling occurs in an adhesion evaluation test which will be described later. Meanwhile, when the thickness of the SiOₓ layer is more than 2.0 µm, it becomes difficult to form the second and subsequent layers as shown in Comparative Example 2 which will be described later.

In the present invention, x of the SiOₓ layer formed as the first layer is 1.5 to 2.0. When x is less than 1.5, discoloration occurs after a high-temperature and high-humidity environmental test as shown in Comparative Example 3 which will be described later.

In the present invention, as the method for forming the laminate in which a plurality of metal oxide layers and/or non-metal oxide layers are laminated as the second and subsequent layers by the electron beam vapor deposition method, a generally known method can be employed. Specifically, a vapor deposition material is irradiated with electrons focused by an electron gun, and is heated and evaporated, thereby forming a thin film.

The metal oxide layer is a layer containing a metal oxide. Specific examples of the metal oxide include titanium oxide, aluminum oxide, zirconium oxide, cerium oxide, bismuth oxide, chromium oxide, iron oxide, hafnium oxide, thallium oxide, tantalum pentoxide, iridium oxide, tungsten oxide, molybdenum oxide, lanthanum oxide, magnesium oxide, samarium oxide, antimony oxide, scandium oxide, tin oxide, yttrium oxide, europium oxide, and zinc oxide, and among them, titanium oxide is preferred.

The non-metal oxide layer is a layer containing a non-metal oxide. Specifically, silicon oxide is preferred as the non-metal oxide.

In the present invention, an aspect in which the metal oxide layer is a TiO₂ layer; the non-metal oxide layer is a SiO₂ layer; and the laminate is obtained by laminating a plurality of these layers is preferred.

Further, in the present invention, an aspect in which the laminate is obtained by laminating 2 to 20 metal oxide layers and/or non-metal oxide layers is preferred, and more preferably 4 to 15 layers, and particularly preferably 5 to 12 layers.

The thickness of the laminate is preferably 0.1 to 1 µm, and more preferably 0.1 to 0.5 µm.

The optical component obtained as described above has excellent durability under high-temperature and high-humidity conditions, and can be suitably used for, for example, lenses for cameras, displays, projectors, copy machines, microscopes, etc., light guide bodies, prisms, mirrors, beam splitters, filters, etc. In particular, it can be suitably used for lenses for VR.

### EXAMPLES

Hereinafter, the present invention will be specifically described by way of examples, but the present invention is not limited thereto.

### <Evaluation of Initial Adhesion>

A sample in which an optical thin film was formed on one side of a molded body was left in an environment in which the temperature was 23°C and the relative humidity was 50% for 24 hours or more, so that the conditions were adjusted. A cellophane tape (CT-15 manufactured by Nichiban Co., Ltd.) was rubbed with a finger to be attached onto the surface of the optical thin film, and then the cellophane tape was quickly peeled off at a right angle. The same procedure was repeated three times. The case where the optical thin film peeled off the first time was rated as Rank C, the case where the optical thin film peeled off the second or third time was rated as Rank B, and the case where the optical thin film did not peel off was rated as Rank A.

### <Evaluation of Adhesion After Environmental Test>

A sample in which an optical thin film was formed on one side of a molded body was placed in a constant temperature and humidity bath, in which the temperature was set at 65°C and the relative humidity was set at 90%, for 96 hours. After that, the sample was taken out from the constant temperature and humidity bath and left in an environment in which the temperature was 23°C and the relative humidity was 50% for 1 hour, so that the conditions were adjusted. A tape test similar to that used for the evaluation of initial adhesion was conducted. The case where peeling occurred the first time was rated as Rank C, the case where peeling occurred the second or third time was rated as Rank B, and the case where peeling did not occur was rated as Rank A.

### <Evaluation of Durability>

A sample in which an optical thin film was formed on one side of a molded body was left in an environment in which the temperature was 23°C and the relative humidity was 50% for 24 hours or more, so that the conditions were adjusted. The sample was placed in a constant temperature and humidity bath, in which the temperature was set at 65°C and the relative humidity was set at 90%, for 96 hours. After that, the sample was taken out from the constant temperature and humidity bath and left in an environment in which the temperature was 23°C and the relative humidity was 50% for 24 hours, so that the conditions were adjusted. The sample surface was observed at 100x magnification with an optical microscope, and a tape test similar to that used for the above-described evaluation was conducted. The case where there was no abnormal appearance such as a crack and the optical thin film peeled off the first time was rated as Rank C, the case where there was no abnormal appearance and the optical thin film peeled off the second or third time was rated as Rank B, and the case where there was no abnormal appearance and the optical thin film did not peel off was rated as Rank A.

### <Evaluation of Optical Characteristics>

The optical characteristics (transmittance, haze) of a sample in which an optical thin film was formed on one side of a molded body were measured using a spectroscopic haze meter SH7000 manufactured by Nippon Denshoku Industries Co., Ltd. In addition, the optical characteristics were further measured after the above-described constant temperature and humidity test. Regarding transmittance, the average rate of change at wavelengths from 380 nm to 780 nm was calculated, and the case where the value was less than 3% was rated as Rank A, the case where the value was 3% or more but less than 5% was rated as Rank B, and the case where the value was 5% or more was rated as Rank C. Regarding haze, the amount of change in haze before and after the constant temperature and humidity test was calculated, and the case where the amount was less than 0.1 was rated as Rank A, the case where the amount was 0.1 or more but less than 0.3 was rated as Rank B, and the case where the amount was 0.3 or more was rated as Rank C.

### <Overall Judgment>

The case where Rank A was given in all of the above-described evaluation of initial adhesion, evaluation of adhesion after environmental test, evaluation of durability, and evaluation of optical characteristics was judged as "pass" as overall judgment, and the case where at least one Rank B or Rank C was given in the evaluations was judged as "fail" as overall judgment.

### Synthesis Example 1 [Production of Vinyl Copolymer Resin]

A copolymer resin (A1') consisting of 75 mol% of methyl methacrylate and 25 mol% of styrene was dissolved in methyl isobutyrate to prepare a 10% by mass solution of methyl isobutyrate. To a 1000-mL autoclave, 500 parts by mass of the 10% by mass solution of methyl isobutyrate containing the copolymer resin (A1') and 1 part by mass of 10% by mass Pd/C were fed, and the mixture was held under a hydrogen pressure of 9 MPa at 200°C for 15 hours, thereby hydrogenating a benzene ring moiety. The catalyst was removed using a filter, and the filtrate was introduced into a solvent-removing apparatus, thereby obtaining a vinyl copolymer resin (A1) in a pellet form. According to the ¹H-NMR measurement, the ratio of the methyl methacrylate structural unit was 75 mol%, and according to the measurement of absorbance at a wavelength of 260 nm, the hydrogenation rate of the benzene ring moiety was 99%.

### Synthesis Example 2 [Production of Vinyl Copolymer Resin]

A vinyl copolymer resin (A2) was obtained in a manner similar to that in Synthesis Example 1, except that a copolymer resin (A2') consisting of 63 mol% of methyl methacrylate and 37 mol% of styrene was used instead of the copolymer resin (A1') used in Synthesis Example 1. According to the ¹H-NMR measurement, the ratio of the methyl methacrylate structural unit was 63 mol%, and according to the measurement of absorbance at a wavelength of 260 nm, the hydrogenation rate of the benzene ring moiety was 99%.

### (Example 1)

The vinyl copolymer resin (A1) obtained in Synthesis Example 1 was injection-molded to prepare a molded body (B1) having a plate-like shape (82 mm×65 mm×t3 mm). Oxygen gas was flowed under vacuum to adjust the absolute pressure to 0.02 PaA, and on one side of the molded body (B1), a SiOₓ layer (x is 1.5 to 2.0) having a thickness of 0.5 µm as a first layer was formed by a resistance heating vapor deposition method. Subsequently, on the SiOₓ layer as the first layer, a laminate consisting of a second layer of TiO₂, a third layer of SiO₂, a fourth layer of TiO₂, a fifth layer of SiO₂, a sixth layer of TiO₂, and a seventh layer of SiO₂ (the thickness of the laminate was 0.5 µm) was formed by an electron beam vapor deposition method to produce an optical component. The results of the evaluation of initial adhesion, evaluation of durability, and evaluation of optical characteristics of the obtained optical component are shown in Table 1 below (the same applies below). The optical component obtained in Example 1 was rated as Rank A in all the evaluations, and the overall judgment thereof was "pass".

### (Example 2)

An optical component was produced in a manner similar to that in Example 1, except that the first layer of Example 1 was changed to a SiOₓ layer (x is 1.5 to 2.0) having a thickness of 1.0 µm. The optical component obtained in Example 2 was rated as Rank A in all the evaluations, and the overall judgment thereof was "pass".

### (Example 3)

An optical component was produced in a manner similar to that in Example 1, except that the first layer of Example 1 was changed to a SiOₓ layer (x is 1.5 to 2.0) having a thickness of 2.0 µm. The optical component obtained in Example 3 was rated as Rank A in all the evaluations, and the overall judgment thereof was "pass".

### (Example 4)

The vinyl copolymer resin (A2) obtained in Synthesis Example 2 was injection-molded to prepare a molded body (B2) having a plate-like shape (82 mm×65 mm×t3 mm). Oxygen gas was flowed under vacuum to adjust the absolute pressure to 0.02 PaA, and on one side of the molded body (B2), a SiOₓ layer (x is 1.5 to 2.0) having a thickness of 0.5 µm as a first layer was formed by the resistance heating vapor deposition method. Subsequently, on the SiOₓ layer as the first layer, a laminate consisting of a second layer of TiO₂, a third layer of SiO₂, a fourth layer of TiO₂, a fifth layer of SiO₂, a sixth layer of TiO₂, and a seventh layer of SiO₂ (the thickness of the laminate was 0.5 µm) was formed by the electron beam vapor deposition method to produce an optical component. The results of the evaluation of initial adhesion, evaluation of adhesion after environmental test, evaluation of durability, and evaluation of optical characteristics of the obtained optical component are shown in Table 1 below (the same applies below). The optical component obtained in Example 4 was rated as Rank A in all the evaluations, and the overall judgment thereof was "pass".

### (Example 5)

An optical component was produced in a manner similar to that in Example 4, except that the first layer of Example 4 was changed to a SiOₓ layer (x is 1.5 to 2.0) having a thickness of 1.0 µm. The optical component obtained in Example 5 was rated as Rank A in all the evaluations, and the overall judgment thereof was "pass".

### (Example 6)

An optical component was produced in a manner similar to that in Example 4, except that the first layer of Example 4 was changed to a SiOₓ layer (x is 1.5 to 2.0) having a thickness of 2.0 µm. The optical component obtained in Example 6 was rated as Rank A in all the evaluations, and the overall judgment thereof was "pass".

### (Comparative Example 1)

The vinyl copolymer resin (A1) obtained in Synthesis Example 1 was injection-molded to prepare a molded body (B1) having a plate-like shape (82 mm×65 mm×t3 mm). On one side of the molded body (B1), a laminate consisting of a first layer of TiO₂, a second layer of SiO₂, a third layer of TiO₂, a fourth layer of SiO₂, a fifth layer of TiO₂, and a sixth layer of SiO₂ (the thickness of the laminate was 0.5 µm) was formed to produce an optical component. A low-reflection-type electron gun was used to heat the film raw materials, and the film formation was performed while generated electrons were deflected by a magnetic field to be captured in order to prevent the electrons from reaching the molded body (B1). The optical component obtained in Comparative Example 1 was rated as Rank A in the evaluation of initial adhesion, evaluation of durability, and evaluation of optical characteristics, and rated as Rank C in the evaluation of adhesion after environmental test. The overall judgment thereof was "fail".

### (Comparative Example 2)

An optical component was produced in a manner similar to that in Comparative Example 1, except that the vinyl copolymer resin (A2) obtained in Synthesis Example 2 was used instead of the vinyl copolymer resin (A1) obtained in Synthesis Example 1. The optical component obtained in Comparative Example 2 was rated as Rank A in the evaluation of initial adhesion, evaluation of durability, and evaluation of optical characteristics, and rated as Rank C in the evaluation of adhesion after environmental test. The overall judgment thereof was "fail".

### (Comparative Example 3)

An attempt was made to produce an optical component in a manner similar to that in Example 1, except that the first layer of Example 1 was changed to a SiOₓ layer (x is 1.5 to 2.0) having a thickness of 3.0 µm, but it was difficult to form the second and subsequent layers, and the overall judgment was "fail".

### (Comparative Example 4)

An optical component was produced in a manner similar to that in Example 5, except that x of the SiOₓ layer as the first layer of Example 5 was changed to be 1.0 or more but less than 1.5 and the absolute pressure in the resistance heating vapor deposition method was adjusted to 0.01 PaA. The optical component obtained in Comparative Example 4 was rated as Rank A in the evaluation of initial adhesion, evaluation of durability, and evaluation of optical characteristics, and rated as Rank C in the evaluation of adhesion after environmental test. The overall judgment thereof was "fail".

### (Comparative Example 5)

An optical component was produced in a manner similar to that in Example 5, except that x of the SiOₓ layer as the first layer of Example 5 was changed to be 1.0 or more but less than 1.5 and the absolute pressure in the resistance heating vapor deposition method was adjusted to 0.04 PaA. The optical component obtained in Comparative Example 5 was rated as Rank A in the evaluation of initial adhesion, evaluation of adhesion after environmental test, and evaluation of average rate of change in transmittance in evaluation of optical characteristics, and rated as Rank C in the evaluation of durability and evaluation of haze before environmental test in evaluation of optical characteristics. The overall judgment thereof was "fail".

### (Comparative Example 6)

An optical component was produced in a manner similar to that in Example 2, except that x of the SiOₓ layer as the first layer of Example 2 was changed to be 1.0 or more but less than 1.5 and the absolute pressure in the resistance heating vapor deposition method was adjusted to 0.04 PaA. The optical component obtained in Comparative Example 6 was rated as Rank A in the evaluation of initial adhesion, evaluation of adhesion after environmental test, and evaluation of average rate of change in transmittance in evaluation of optical characteristics, and rated as Rank C in the evaluation of durability and evaluation of haze before environmental test in evaluation of optical characteristics. The overall judgment thereof was "fail".

**Table 1**

| | Material | Thickness of SiOₓ layer [µm] | Absolute pressure [PaA] | Control of reflected electrons | Evaluation of durability | Evaluation of initial adhesion | Evaluation of adhesion after environmental test | Evaluation of optical characteristics | | Overall judgment |
|---|---|---|---|---|---|---|---|---|---|---|
| | | | | | | | | Average rate of change in transmittance | Haze before environmental test | |
| Example 1 | A1 | 0.5 | 0.02 | Not performed | A | A | A | A | A | Pass |
| Example 2 | A1 | 1.0 | 0.02 | Not performed | A | A | A | A | A | Pass |
| Example 3 | A1 | 2.0 | 0.02 | Not performed | A | A | A | A | A | Pass |
| Example 4 | A2 | 0.5 | 0.02 | Not performed | A | A | A | A | A | Pass |
| Example 5 | A2 | 1.0 | 0.02 | Not performed | A | A | A | A | A | Pass |
| Example 6 | A2 | 2.0 | 0.02 | Not performed | A | A | A | A | A | Pass |
| Comparative Example 1 | A1 | 0 | - | Performed | A | A | C | A | A | Fail |
| Comparative Example 2 | A2 | 0 | - | Performed | A | A | C | A | A | Fail |
| Comparative Example 3 | A1 | 3.0 | Impossible to carry out | | | | | | | Fail |
| Comparative Example 4 | A2 | 1.0 | 0.01 | Not performed | A | A | C | A | A | Fail |
| Comparative Example 5 | A2 | 1.0 | 0.04 | Not performed | C | A | A | A | C | Fail |
| Comparative Example 6 | A1 | 1.0 | 0.04 | Not performed | C | A | A | A | C | Fail |

## Claims

1. A method for manufacturing an optical component, the method comprising
a step of producing a molded body by molding a resin composition, and
a step of forming an optical thin film on at least a portion of the surface of the molded body, wherein:
the resin composition comprises a vinyl copolymer resin (A) comprising a structural unit (a) represented by general formula (1) and a structural unit (b) represented by general formula (2): 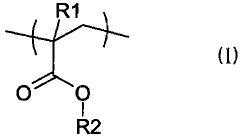
wherein in general formula (1): R1 represents a hydrogen atom or a methyl group; R2 represents a group having 1 to 16 carbon atoms which has a hydrocarbon group, which may have a hydroxyl group or an alkoxy group; and in a case where a plurality of the structural units (a) exist, R1 and R2 respectively may be the same or different from each other, 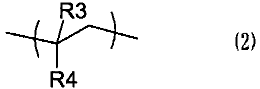
wherein in general formula (2): R3 represents a hydrogen atom or a methyl group; R4 represents a phenyl group, a cyclohexadienyl group, a cyclohexenyl group or a cyclohexyl group, which may have at least one substituent selected from the group consisting of a hydrocarbon group having 1 to 4 carbon atoms, a hydroxyl group, an alkoxy group and a halogen atom; and in a case where a plurality of the structural units (b) exist, R3 and R4 respectively may be the same or different from each other; and
the step of forming the optical thin film comprises forming a SiOₓ layer (x is 1.5 to 2.0) having a thickness of 0.5 to 2.0 µm as a first layer by a resistance heating vapor deposition method, and furthermore forming a laminate in which a plurality of metal oxide layers and/or non-metal oxide layers are laminated as second and subsequent layers by an electron beam vapor deposition method.

2. The method according to claim 1, wherein the metal oxide layers are TiO₂ layers and the non-metal oxide layers are SiO₂ layers.

3. The method according to claim 1, wherein the laminate is obtained by laminating 2 to 20 metal oxide layers and/or non-metal oxide layers.

4. The method according to claim 1, wherein the laminate has a thickness of 0.1 to 1 µm.

5. The method according to claim 1, wherein the molded body has a thickness of 0.5 to 20 mm.

6. The method according to claim 1, wherein in general formula (1), R1 and R2 represent a methyl group, and wherein in general formula (2): R3 represents a hydrogen atom; and R4 represents a cyclohexyl group which does not have a substituent.

7. The method according to claim 1, wherein a ratio of the structural unit (a) to the total of the structural units (a) and (b) is 30 to 80 mol%.

8. The method according to claim 1, wherein the step of forming the optical thin film comprises flowing oxygen gas under vacuum to adjust an absolute pressure to 0.01 to 0.04 PaA, and forming a SiOₓ layer (x is 1.5 to 2.0) having a thickness of 0.5 to 2.0 µm as a first layer by a resistance heating vapor deposition method.
